# EUROPEAN PATENT APPLICATION

(11) **EP 2 037 000 A2**
(43) Date of publication of application: **18.03.2009**
(21) Application number: 08162586.5
(22) Date of filing: 19.08.2008
(51) Int. Cl.: C23C 14/22, C23C 28/00

(54) **A method and apparatus for depositing a coating onto a substrate**

(30) Priority: 14.09.2007 SE 0702060
(71) Applicant: Sandvik Intellectual Property AB, 811 81 Sandviken (SE)
(72) Inventor: Rodmar, Markus, SE-186 35 Vallentuna (SE); Selinder, Torbjörn, SE 117 61 Stockholm (SE)
(74) Representative: Hägglöf, Henrik

(57) **Abstract**

The present invention relates to a method for depositing a coating onto a substrate. The method comprises:
- depositing said coating by arc evaporation;
- depositing said coating by dual magnetron sputtering;
said depositing being performed in sequence or simultaneously.

## Description

### Field of the invention

The present invention relates in a first aspect to a method for depositing a coating onto a substrate.

According to a second aspect the present invention relates to an apparatus operable to deposit a coating onto a substrate.

According to a third aspect the present invention relates to at least one computer program product for depositing a coating onto a substrate.

### Background of the invention

Arc evaporation is a widely used deposition method when depositing coatings onto cutting tools with Physical Vapour Deposition (PVD). The advantages are high adhesion of the coatings often together with high toughness and high wear resistance. The adhesion is very much dependent on the strong ionization in the arc-plasma. The disadvantages are, however, metallic macro particles, droplets, on the coatings and the difficulties to deposit insulating layers. The droplets are a result of the local rapid melting of the target during the arc-process and the size of the droplets can be in the same order as the coating thickness. The wear of the cutting tool often initiates at the droplets since that material is softer than the coating and the droplets can rather easily tear off when exposed to the working material during machining. The droplets also result in a rough surface, which increases the wear during machining, especially when machining cladding materials as, e.g., stainless steel. Insulating layers as crystalline Al₂O₃ are very difficult to deposit in PVD, and especially with arc-evaporation due to the fact that all areas including the anode are coated with insulating layers. The deposition of insulating layers with standard DC-arc evaporation results in an electrically disappearing anode, charging effects and unintentional arcing to the anode and cathode.

Magnetron sputtering is not as widely used as deposition method for cutting tools, partly because it results in less adherent coatings, which is due to a lower degree of ionization of the plasma compared to, e.g., arc-evaporation. Standard magnetron sputtering has also the disadvantages when depositing insulating layers with electrically disappearing (insulating) anode and anode-arcs.

It is however possible to deposit smooth coatings with small amounts of defects, and to deposit a large variety of different materials and the composition can easily be controlled by adjusting the composition of the targets.

Dual magnetron sputtering (DMS) is a sputtering method which utilizes a bipolar pulsed power supply connected to two magnetrons, which alternatingly act as cathode and anode during the pulsing of the power supply. That is, there is no separate anode, which can become coated. Dual magnetron sputtering can therefore be used both for depositing electrically insulating coatings as, e.g., thick crystalline Al₂O₃ (see US-5,698,314) as well as smooth conducting coatings as, e.g., (Ti,Al)N (See WO-A1-2006/041366). Dual magnetron sputtering shares some advantages, such as smooth coatings, many different kinds of source materials, and the main disadvantage, such as less adhesion to the substrate, with the other sputtering methods. However, it is possible to deposit thick crystalline coatings with the DMS-technique, which is not possible when using a deposition system with a disappearing anode, e.g., with standard arc-evaporation or standard sputtering techniques. Furthermore, the DMS-technique can, as in contrast to standard sputtering, provide a simple control of the composition of coating materials with more than one metallic constituent by only adjusting the process parameters (See WO-A1-2006/041366). The composition can therefore easily be changed also during the process and not only by adjusting the target composition as in standard magnetron sputtering.

Electrically insulating layers often have a high resistance against thermal and oxidation wear, and oxidation, but have less wear resistance and toughness than refractory metallic layers as, e.g., TiN or (Ti,Al)N.

It is difficult to deposit thick insulating coatings such as highly crystalline Al₂O₃ with any other method than DMS.

The combination of sputtering and arc-evaporation process is previously known, from, e.g., US-5,306,407, EP-A1-0 668 369 and US-A-4,877,505. The method disclosed in US-5,306,407 specifically includes a metal ion etching step prior to the coating process. The preferred method in EP-A1-0 668 369 is to start the deposition process with a sputtering process, which is in contradiction to the general belief, i.e., that the arc-evaporation process results in a higher adhesion due to a higher degree of ionization than in sputtering.

WO-A1-02/070776 discloses a method with simultaneous use of several kinds of arc evaporation and magnetron sputtering techniques. The main advantage is said to be decreased poisoning, i.e., the surface of the target is in reactive sputtering more and more covered by the produced coating, e.g., SiN when depositing SiN by arc evaporation of Si in a nitrogen atmosphere.

US-A1-2001/0008707 relates to a method to deposit coloured coatings onto articles with low temperature resistance by combining a first layer with arc evaporation and subsequent sputtered layers.

US-5,234,561 relates to a method, and a system for subsequent arc evaporation and magnetron sputtering. The application is cosmetic on, e.g., jewelry, and the main object is to replace gold with a coating (TiN) with similar colour and good adhesion.

US-5,698,314 and US-5,879,823 relate to a PVD deposited Al₂O₃ layer together with other coatings, but the combination of an arc evaporated layer and a DMS layer is not mentioned.

Equipment for a deposition process with one or two doors, and shutters is described in US-A1-2001/0008707, US-A1-2006/0102077 and US-B1-6,315,877. The difficult task in order to implement cost effective coating equipment with high deposition rates and/or many different target material and/or different kind of sources is to realize as many sources as possible around the substrate table together with one or several heaters and large flanges for the pumping system. E.g., a powerful heating system for deposition at a higher temperature reduces the space for arc or sputtering sources. The deposition rate does not alone depend on the number of sources, but also the utilization of these sources during the process. A high number of sources can also result in a stack of layers or multilayers with different compositions. The equipment described in US-B1-6,315,877 differs from most coating equipments in that the heater is placed in the centre of the recipient. This results in more space for sources at the walls, but complicates the removal of the substrate tables.

None of the above mentioned deposition techniques can alone neither deposit coating systems with good adhesion, high wear resistance and toughness, and high thermal and oxidation resistance nor deposit coating systems with a large variation in coating composition, by only adjusting the coating parameters, combined with a well adherent wear resistant inner layer.

### Summary of the invention

The above mentioned problems are solved by a method for depositing a coating onto a substrate according to Claim 1. The method comprises:
- depositing by arc evaporation;
- depositing by dual magnetron sputtering;
said depositing being performed in sequence or simultaneously.

The main advantages with this method are that it is possible to deposit coating systems with good adhesion, high wear resistance and toughness, high thermal and oxidation resistance, a large variation in coating composition, and a smooth surface of the coating system.

A further advantage in this context is achieved if said coating comprises at least one layer deposited by arc evaporation and at least one layer deposited by dual magnetron sputtering.

According to another embodiment, it is an advantage if said coating comprises at least one layer deposited by arc evaporation and dual magnetron sputtering.

Furthermore, it is an advantage in this context if said coating comprises an innermost layer deposited by arc evaporation.

A further advantage in this context is achieved if said coating comprises an outermost layer deposited by dual magnetron sputtering.

Furthermore, it is an advantage in this context if said method also comprises:
- plasma-etching said substrate with metallic ions.

A further advantage in this context is achieved if said method also comprises:
- plasma-etching said substrate with non-metallic ions.

Furthermore, it is an advantage in this context if at least one of said layer(s) deposited by dual magnetron sputtering is electrically insulating.

A further advantage in this context is achieved if at least one of said insulating layers is an oxide layer.

According to another embodiment, it is an advantage if at least one of said insulating layers is an Al₂O₃ layer.

Furthermore, it is an advantage in this context if said substrate is a cutting tool substrate.

A further advantage in this context is achieved if said method is performed in vacuum, without breaking said vacuum.

The above mentioned problems are also solved with an apparatus operable to deposit a coating onto a substrate according to Claim 13. The apparatus comprises a vacuum chamber for receiving the substrates. The apparatus comprises a middle part, a first door part, and a second door part. The first and second door parts are operable between a closed position in which the middle part and the first and second door parts provide the vacuum chamber, and an open position. The apparatus also comprises a number, n, of flanges arranged on the first and second door parts. The n number of flanges each comprises either one or several magnetron sputtering sources, and/or one or several arc evaporation sources. Furthermore, the apparatus also comprises movable shutters in front of each source. The apparatus also comprises a control means operable to control at least one arc evaporation source to deposit by arc evaporation, and to control at least two magnetron sputtering sources to deposit by dual magnetron sputtering. The at least one arc evaporation source and the at least two magnetron sputtering sources are operable to run in sequence or simultaneously.

The main advantages with this apparatus are that it is possible to deposit coating systems with good adhesion, high wear resistance and toughness, high thermal and oxidation resistance, a large variation in coating composition, and a smooth surface of the coating system.

A further advantage in this context is achieved if said coating comprises at least one layer deposited by said at least one arc evaporation source, and at least one layer deposited by said at least two magnetron sputtering sources.

According to another embodiment it is an advantage if said coating comprises at least one layer deposited by said at least one arc evaporation source, and said at least two magnetron sputtering sources.

Furthermore, it is an advantage in this context if said control means is operable to control said at least one arc evaporation source to deposit an innermost layer comprised in said coating.

A further advantage in this context is achieved if said control means is operable to control said at least two magnetron sputtering sources to deposit an outermost layer comprised in said coating.

Furthermore, it is an advantage in this context if said apparatus also comprises a pumping system with pump flanges arranged on the top side of said middle part, said pumping system is operable to provide a vacuum in said vacuum chamber.

A further advantage in this context is achieved if said apparatus also comprises a first heater means arranged in a first outer side of said middle part, and a second heater means arranged in a second outer side of said middle part, wherein said first and second heater means are operable to achieve process temperatures up to 800° in said vacuum chamber.

Furthermore, it is an advantage in this context if said first and second heater means comprise rods made of a resistance heating alloy.

A further advantage in this context is achieved if said vacuum chamber, when said first and second door parts are in said closed position, has a cross section of an octagon, and in that n is equal to six.

Furthermore, it is an advantage in this context if said apparatus also comprises a means operable to plasma-etch said substrate with metallic ions.

According to another embodiment, it is an advantage if said apparatus also comprises a means operable to plasma-etch said substrate with non-metallic ions.

A further advantage in this context is achieved if at least one of said layer(s) deposited by said at least two magnetron sputtering sources is electrically insulating.

Furthermore, it is an advantage in this context if at least one of said insulating layers is an oxide layer.

According to another embodiment, it is an advantage if at least one of said insulating layers is an Al₂O₃ layer.

A further advantage in this context is achieved if said substrate is a cutting tool substrate.

Furthermore, it is an advantage in this context if said at least two magnetron sputtering sources and said at least one arc evaporation source are operable in vacuum, without breaking said vacuum, i.e., without increasing the pressure above 1 mbar in said vacuum chamber.

The above mentioned problems are also solved with at least one computer program product according to Claim 29. The at least one computer program product is/are directly loadable into the internal memory of at least one digital computer, and comprises software code positions for performing the steps of the method according to the present invention when the at least one product is/are run on the at least one computer.

The main advantages with this computer program product are that it is possible to deposit coating systems with good adhesion, high wear resistance and toughness, high thermal and oxidation resistance, a larger variation in coating composition, and a smooth surface of the coating system.

It will be noted that the term "comprises/comprising" as used in this description is intended to denote the presence of a given characteristic, step or component, without excluding the presence of one or more other characteristic, features, integers, steps, components or groups thereof.

Embodiment of the invention will now be described with reference to the accompanying drawings, in which:

### Brief description of the drawings

Fig. 1 is a flow chart of a first embodiment of a method for depositing a coating onto a substrate according to the present invention;
Fig. 2 is a flow chart of a second embodiment of the method for depositing a coating onto a substrate according to the present invention;
Fig. 3 is a schematic perspective view of an apparatus operable to deposit a coating onto a substrate according to the present invention;
Fig. 4 is a schematic perspective view of the apparatus disclosed in Fig. 3; and
Fig. 5 schematically shows a number of computer program products according to the present invention.

### Detailed description of the preferred embodiments

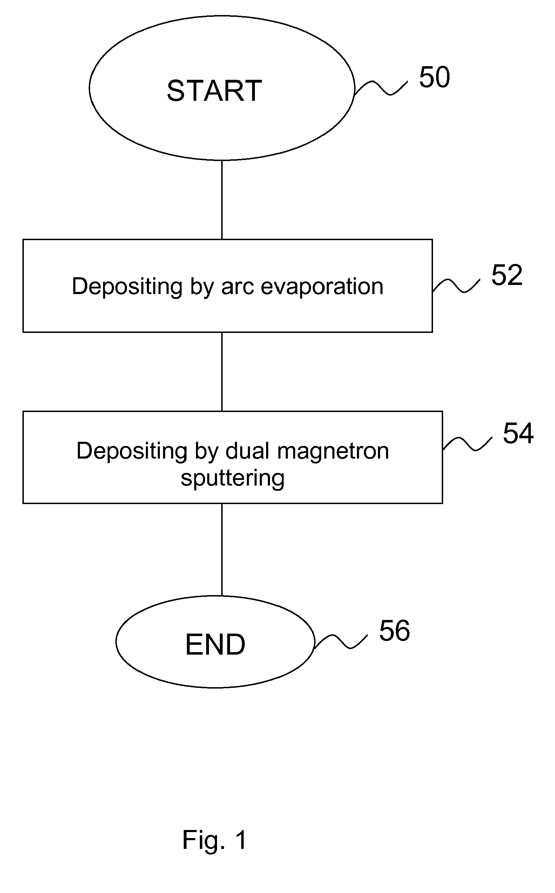

In Fig. 1 there is disclosed a flow chart of a first embodiment of a method for depositing a coating onto a substrate according to the present invention. The method begins at block 50. The method continues, at block 52, with the step: depositing by arc evaporation. Thereafter, the method continues, at block 54, with the step: depositing by dual magnetron sputtering. The method is completed at block 56.

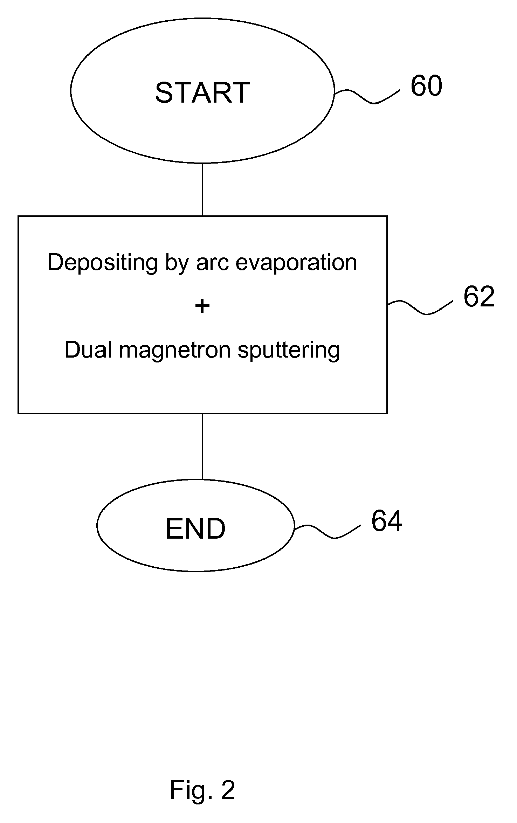

In Fig. 2 there is disclosed a flow chart of a second embodiment of a method for depositing a coating onto a substrate according to the present invention. The method begins at block 60. Thereafter, the method continues, at block 62, with the step: depositing by arc evaporation, and simultaneously depositing by dual magnetron sputtering. The method is completed at block 64.

As is apparent from Figs. 1 and 2, the difference between the embodiments disclosed therein is that in the first embodiment of the method the steps are performed in sequence, but in the second embodiment of the method the same steps are performed simultaneously.

According to another embodiment of the method according to the present invention, the coating comprises at least one layer deposited by arc evaporation and at least one layer deposited by dual magnetron sputtering.

In another alternative of the method, the coating comprises at least one layer deposited by arc evaporation and dual magnetron sputtering.

Furthermore, the coating can also comprise an innermost layer deposited by arc evaporation. Hereby, is achieved an inner layer with good adhesion.

In a further embodiment of the method, the coating can also comprise an outermost layer deposited by dual magnetron sputtering. Hereby, is achieved a smooth outer layer.

Furthermore, the method can also comprise: to plasma-etch the substrate with metallic ions or alternatively with non metallic ions.

According to another alternative, the method also comprises: to plasma-etch the substrate with non-metallic ions.

In a further embodiment of the method, at least one of the layer(s) deposited by dual magnetron sputtering is electrically insulating.

Furthermore, in one embodiment of the method, at least one of the insulating layers is an oxide layer.

In a further embodiment of the method, at least one of the insulating layers is an Al₂O₃ layer.

Furthermore, the substrate can be a cutting tool substrate.

Preferably, the method according the present invention is performed in vacuum, without breaking the vacuum.

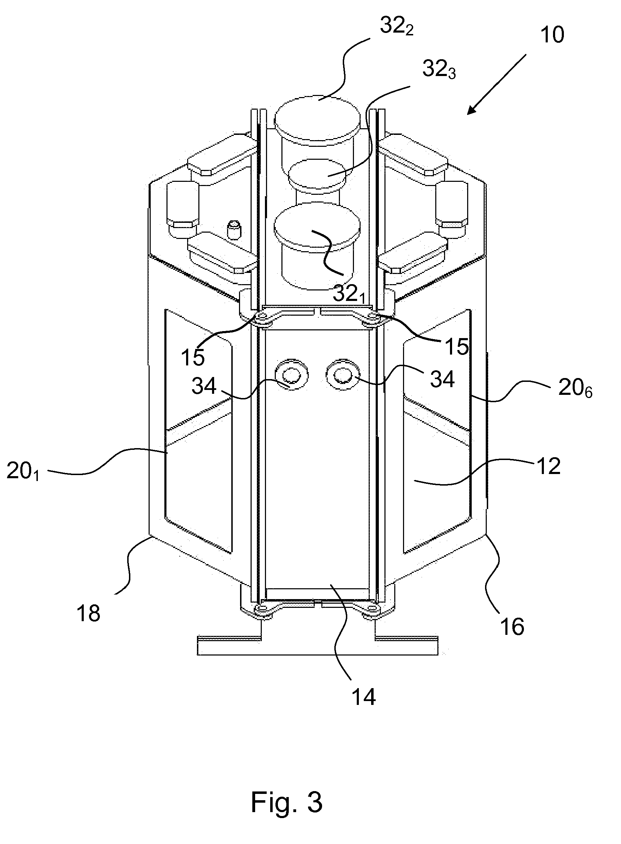

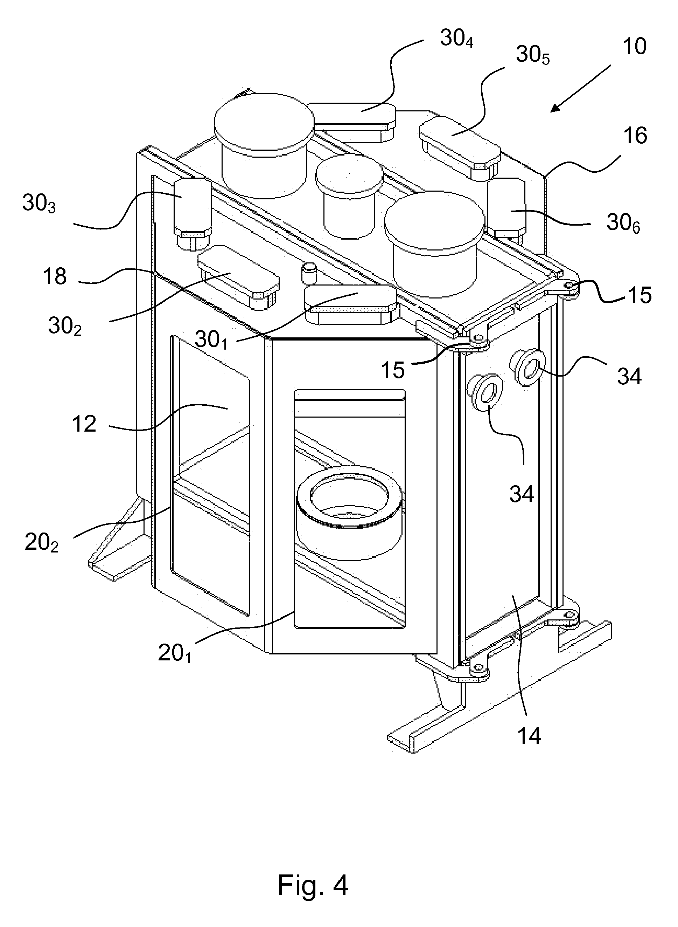

In Figs. 3 and 4, there are disclosed perspective views of an apparatus 10 operable to deposit a coating onto a substrate according to the present invention.

The apparatus 10 comprises a vacuum chamber 12 for receiving the substrates. The apparatus 10 has three different main parts, namely a middle part 14, a first door part 16, and a second door part 18. The first and second door parts 16, 18 are in one end connected to the middle part 14 by hinges 15, as shown in Figs. 3 and 4. This means that the first and second door parts 16, 18 can be opened in order to place the substrate on the substrate table before the depositing process, or to take out the treated substrate when the deposition process is completed. It is pointed out that in Figs. 3 and 4, the door parts 16, 18 are only disclosed in the closed position, whereby it is possible to achieve vacuum in the vacuum chamber 12.

As is apparent in Figs. 3 and 4, in this particular case, the apparatus 10 comprises six flanges 20₁-20₆ arranged on the first and second door parts 16, 18. Each of the flanges 20₁-20₆ comprises either one or several magnetron sputtering sources (not shown) and/or one or several arc evaporation sources (not shown). The apparatus 10 also comprises a control means (not shown) operable to control at least one arc evaporation source to deposit by arc evaporation, and to control at least two magnetron sputtering sources to deposit by dual magnetron sputtering. With this apparatus 10 the at least one arc evaporation source, and the at least two magnetron sputtering sources are operable to run in sequence or simultaneously. The apparatus 10 also comprises movable shutters (not shown) arranged in front of each source. As is apparent in Figs. 3 and 4, there are disclosed six top flanges 30₁-30₆ for the movable shutters. The movable shutters are operable between an open position, and a closed position operable to avoid unintended exposure of a surface to radiant flux. The shutters are normally in the closed position, and are only in the open position when some of the sources is/are used. It is pointed out that the shutters are controlled individually.

In order to provide vacuum in the vacuum chamber 12, the apparatus 10 comprises a pumping system (not shown) with pump flanges 32₁, 32₂, 32₃ arranged on the top side of the middle part 14 (see Figs. 3 and 4).

The apparatus 10 also comprises a first heater means (not shown) arranged in a first outer side of the middle part 14. In Figs. 3 and 4 there are disclosed two flanges 34 for the first heater means. The apparatus 10 also comprises a second heater means (not shown) arranged in a second outer side of the middle part 14. The first and second heater means are operable to achieve process temperatures up to 800° C in the vacuum chamber 12. The first and second heater means can be in the form of rods made of a resistance heating alloy.

As apparent in Figs. 3 and 4, the apparatus 10, and consequently the vacuum chamber 12, in the disclosed embodiment, has a cross section of an octagon, when the first and second door parts 16, 18 are in the closed position. In this disclosed embodiment, the apparatus 10, as pointed out above, has six flanges 20₁-20₆.

In the most general case, the apparatus 10 comprises a number, n, of flanges 20₁-20ₙ arranged on the first and second door parts 16, 18. This means that the apparatus 10, and consequently the vacuum chamber 12 will have a cross section with n+2 sides.

According to one embodiment of the apparatus 10, the coating comprises at least one layer deposited by the at least one arc evaporation source, and at least one layer deposited by the at least two magnetron sputtering sources.

According to another embodiment of the apparatus 10, the coating comprises at least one layer deposited by the at least one arc evaporation source, and the at least two magnetron sputtering sources.

Furthermore, the control means can be operable to control the at least one arc evaporation source to deposit an innermost layer comprised in the coating.

According to a further embodiment of the apparatus 10, the control means can be operable to control the at least two magnetron sputtering sources to deposit an outermost layer comprised in the coating.

Furthermore, the apparatus 10 can also comprise a means (not shown) operable to plasma-etch substrate with metallic ions.

According to another embodiment of the apparatus 10, it also comprises a means (not shown) operable to plasma-etch the substrate with non-metallic ions.

Furthermore, according to another alternative, at least one of the layer(s) deposited by the at least two magnetron sputtering sources is electrically insulating.

According to another embodiment of the apparatus 10, at least one of the insulating layers is an oxide layer.

Furthermore, according to another alternative, at least one of the insulating layers is an Al₂O₃ layer.

Preferably, the substrate is a cutting tool substrate.

According to a further embodiment of the apparatus 10, the at least two magnetron sputtering sources, and at least one arc evaporation source are operable in vacuum, without breaking the vacuum.

The design of the apparatus 10 allows for high process temperature, low base-pressure, high productivity and/or up to six different target materials, and the ability to produce layers of all six target materials having a uniform layer thickness, and the possibility to easily change from arc to magnetron sputtering sources.

The arc evaporation sources and the magnetron sputtering sources can be run in sequence or simultaneously. A simultaneous deposition results in multilayered or co-deposited layers.

The multilayered coatings are periodic or aperiodic depending on the design of the substrate table.

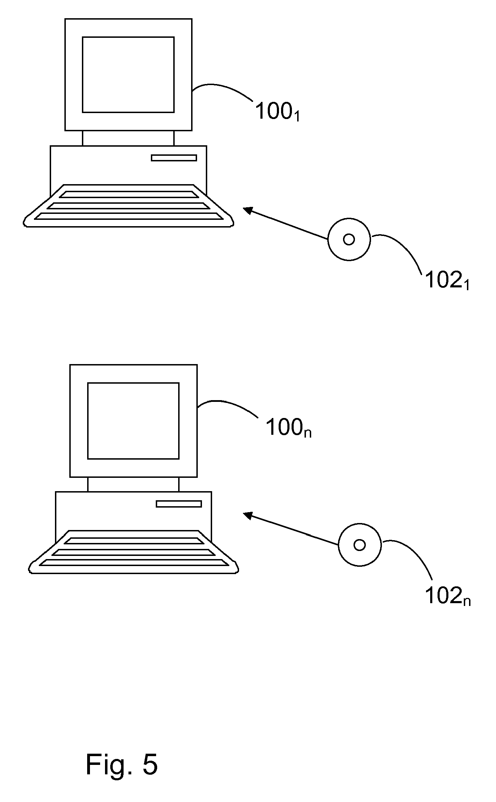

In Fig. 5, some computer program products 102₁,..., 102ₙ according to the present invention are schematically shown. In Fig. 5, n different digital computers 100₁,..., 100ₙ are shown, where n is an integer. In Fig. 5, n different computer program products 102₁,..., 102ₙ are shown, here shown in different form of CD discs. The different computer program products 102₁,..., 102ₙ are directly loadable into the internal memory of the n different computers 100₁,..., 100ₙ. Each computer program product 102₁,..., 102ₙ comprises software code portions for executing all the steps according to Fig. 1, or Fig. 2, when the product/products 102₁,..., 102ₙ is/are run on the computers 100₁,..., 100ₙ. The computer program products 102₁,..., 102ₙ may, for instance, be in the form of diskettes, RAM discs, magnetic tapes, magneto-optical discs or some other suitable products.

The invention is not limited to the described embodiments. It will be evident for those skilled in the art that many different modifications are feasible within the scope of the following Claims.

## Claims

1. A method for depositing a coating onto a substrate, which method comprises:
- depositing said coating by arc evaporation;
- depositing said coating by dual magnetron sputtering;
said depositing being performed in sequence or simultaneously.

2. A method for depositing a coating onto a substrate according to Claim 1, **characterized in that** said coating comprises at least one layer deposited by arc evaporation and at least one layer deposited by dual magnetron sputtering.

3. A method for depositing a coating onto a substrate according to Claim 1 or 2, **characterized in that** said coating comprises at least one layer deposited by arc evaporation and dual magnetron sputtering.

4. A method for depositing a coating onto a substrate according to Claim 2 or 3, **characterized in that** said coating comprises an innermost layer deposited by arc evaporation.

5. A method for depositing a coating onto a substrate according to any one of Claims 2 - 4, **characterized in that** said coating comprises an outermost layer deposited by dual magnetron sputtering.

6. A method for depositing a coating onto a substrate according to any one of Claims 1 - 5, **characterized in that** said method also comprises:
- plasma-etching said substrate with metallic ions.

7. A method for depositing a coating onto a substrate according to any one of Claims 1 - 5, **characterized in that** said method also comprises:
- plasma-etching said substrate with non-metallic ions.

8. A method for depositing a coating onto a substrate according to any one of Claims 2 - 7, **characterized in that** at least one of said layer(s) deposited by dual magnetron sputtering is electrically insulating.

9. A method for depositing a coating onto a substrate according to Claim 8, **characterized in that** at least one of said insulating layers is an oxide layer.

10. A method for depositing a coating onto a substrate according to Claim 8 or 9, **characterized in that** at least one of said insulating layers is an Al₂O₃ layer.

11. A method for depositing a coating onto a substrate according to any one of Claims 1 - 10, **characterized in that** said substrate is a cutting tool substrate.

12. A method for depositing a coating onto a substrate according to any one of Claims 1 - 11, **characterized in that** said method is performed in vacuum, without breaking said vacuum.

13. An apparatus (10) operable to deposit a coating onto a substrate, wherein said apparatus (10) comprises a vacuum chamber (12) for receiving said substrate, said apparatus (10) comprises a middle part (14), and a first door part (16), and a second door part (18), wherein said first and second door parts (16, 18) are operable between a closed position in which said middle part (14) and said first and second door parts (16, 18) provide said vacuum chamber (12), and an open position, said apparatus (10) also comprising a number, n, of flanges (20₁, ..., 20ₙ) arranged on said first and second door parts (16, 18), said n number of flanges (20₁, ..., 20ₙ) comprises each either one or several magnetron sputtering sources, and/or one or several arc evaporation sources, said apparatus (10) also comprises movable shutters in front of each source, wherein said apparatus (10) also comprises a control means operable to control at least one arc evaporation source to deposit by arc evaporation and to control at least two magnetron sputtering sources to deposit by dual magnetron sputtering wherein said at least one arc evaporation source and said at least two magnetron sputtering sources are operable to run in sequence or simultaneously.

14. An apparatus (10) operable to deposit a coating onto a substrate according to Claim 13, **characterized in that** said coating comprises at least one layer deposited by said at least one arc evaporation source, and at least one layer deposited by said at least two magnetron sputtering sources.

15. An apparatus (10) operable to deposit a coating onto a substrate according to Claim 13 or 14, **characterized in that** said coating comprises at least one layer deposited by said at least one arc evaporation source, and said at least two magnetron sputtering sources.

16. An apparatus (10) operable to deposit a coating onto a substrate according to Claim 14 or 15, **characterized in that** said control means is operable to control said at least one arc evaporation source to deposit an innermost layer comprised in said coating.

17. An apparatus (10) operable to deposit a coating onto a substrate according to any one of Claims 14 - 16, **characterized in that** said control means is operable to control said at least two magnetron sputtering sources to deposit an outermost layer comprised in said coating.

18. An apparatus (10) operable to deposit a coating onto a substrate according to any one of Claims 13 - 17, **characterized in that** said apparatus (10) also comprises a pumping system with pump flanges arranged on the top side of said middle part (14), said pumping system is operable to provide a vacuum in said vacuum chamber (12).

19. An apparatus (10) operable to deposit a coating onto a substrate according to any one of Claims 13 - 18, **characterized in that** said apparatus (10) also comprises a first heater means arranged in a first outer side of said middle part (14), and a second heater means arranged in a second outer side of said middle part (14), wherein said first and second heater means are operable to achieve process temperatures up to 800° in said vacuum chamber (12).

20. An apparatus (10) operable to deposit a coating onto a substrate according to Claim 19, **characterized in that** said first and second heater means comprises rods made of a resistance heating alloy.

21. An apparatus (10) operable to deposit a coating onto a substrate according to any one of Claims 13 - 20, **characterized in that** said vacuum chamber (12), when said first and second door parts (16, 18) are in said closed position, has a cross section of an octagon, and **in that** n is equal to six.

22. An apparatus (10) operable to deposit a coating onto a substrate according to any one of Claims 13 - 21, **characterized in that** said apparatus (10) also comprises a means operable to plasma-etch said substrate with metallic ions.

23. An apparatus (10) operable to deposit a coating onto a substrate according to any one of Claims 13 - 21, **characterized in that** said apparatus (10) also comprises a means operable to plasma-etch said substrate with non-metallic ions.

24. An apparatus (10) operable to deposit a coating onto a substrate according to any one of Claims 14 - 23, **characterized in that** at least one of said layer(s) deposited by said at least two magnetron sputtering sources is electrically insulating.

25. An apparatus (10) operable to deposit a coating onto a substrate according to Claim 24, **characterized in that** at least one of said insulating layers is an oxide layer.

26. An apparatus (10) operable to deposit a coating onto a substrate according to Claim 24 or 25, **characterized in that** at least one of said insulating layers is an Al₂O₃ layer.

27. An apparatus (10) operable to deposit a coating onto a substrate according to any one of Claims 13 - 26, **characterized in that** said substrate is a cutting tool substrate.

28. An apparatus (10) operable to deposit a coating onto a substrate according to any one of Claims 13 - 27, **characterized in that** said at least two magnetron sputtering sources and said at least one arc evaporation source are operable in vacuum, without breaking said vacuum.

29. At least one computer program product (102₁, ..., 102ₙ) directly loadable into the internal memory of at least one digital computer (100₁, ..., 100ₙ), comprising software code portions for performing the steps of Claim 1 when said at least one product (102₁, ..., 102ₙ) is/are run on said at least one computer (100₁, ..., 100ₙ).
